# EUROPÄISCHE PATENTANMELDUNG

(11) **EP 0 993 049 A1**
(43) Veröffentlichungstag der Anmeldung: **12.04.2000**
(21) Anmeldenummer: 99118915.0
(22) Anmeldetag: 24.09.1999
(51) Int. Cl.: H01L 29/78, H01L 29/423, H01L 29/417, H01L 21/336

(54) **Vertikaler Feldeffekttransistor mit ringförmigem Graben-Gate und Verfahren zu dessen Herstellung**

(30) Priorität: 30.09.1998 DE 19845003
(71) Anmelder: SIEMENS AKTIENGESELLSCHAFT, 80333 München (DE)
(72) Erfinder: Schamberger, Florian, 83435 Bad Reichenhall (DE); Schneider, Helmut, 80993 München (DE); Lindolf, Jürgen, Dr., 86316 Friedberg (DE); Le, Thoai-Thai, 81737 München (DE)

(57) **Zusammenfassung**

Der erfindungsgemäße vertikale MOS-Transistor ist gekennzeichnet durch ein in einem Graben (2) angeordnetes Gate (13), wobei ein Kanal (10) sowie Source (9) und Drain (5) im Substrat an der Grabenwand angeordnet sind. Das Gate umschließt ringförmig einen Drainanschluß (16), der sich von der Substratoberfläche bis zum am Grabenboden angeordneten Drain erstreckt. Durch Einsatz einer Schrägimplantation bei der Erzeugung des Gates können auf einem Substrat mit verschiedene breiten Gräben vertikale Transistoren mit verschiedenen Kanallängen hergestellt werden.

## Beschreibung

Die Forderung nach hoher Integrationsdichte bei integrierten Schaltungen bedeutet für Feldeffekttransistoren insbesondere eine Reduktion der Gatelänge. Bei Gatelängen von beispielsweise 0,5 bis 0,2 µm und darunter hat dies eine starke Zunahme der Kurzkanaleffekte zur Folge, beispielsweise:
1) Short Channel Effect: der stärkerer Einfluß der Raumladungszonen von Source- sowie Draingebiet bewirkt eine Abnahme der Schwellenspannung Uₜₕ.
2) Schmalkanaleffekt (Narrow Width Effect): der im Verhältnis zur Kanalbreite steigende Anteil der Kanalrandbereiche mit radialer Raumladungszone führt zu einer Zunahme von Uₜₕ.
3) Punch Through Effect: der für kleinere Gatelängen auftretende Überlapp, der von den Drain- und Sourcegebieten in den Kanal auslaufenden Raumladungszonen bewirkt einen zunehmenden Abbau der Potentialbarriere im Kanal. Somit ergibt sich ein drastischer Anstieg der Leckströme unterhalb der Schwellspannung sowie ein schlechteres On/Off-Strom-Verhalten. Um die Leckstromdichte gering zu halten, muß die Gateoxyddicke verringert werden. Dies beeinflußt wiederum die Spannungsfestigkeit, die Lebensdauer sowie die Stromtragfähigkeit des Transistors negativ.

Um nachteilige Kurzkanaleffekte trotz hohe Integrationsdichte zu vermeiden, sind vertikale Feldeffekttransistoren bekannt, d.h. der Kanal ist relativ zur Substratoberfläche vertikal angeordnet. Damit sind größere Gatelängen möglich, ohne den horizontalen Platzbedarf zu erhöhen. Ein Beispiel für einen derartigen vertikalen Transistor ist der sogenannte Surrounding Gate Transistor, bei dem ein vertikaler Kanal allseits von einem Gate umgeben ist. Ein solcher SGT-Transistor ist in dem Artikel von K. Sunoushi et al. in IEDM 98-23, 2.1.1. beschrieben. Das Gate kontrolliert dabei alle vier Seiten des Kanals. Nachteilig bei diesem Konzept ist die geringe Ladungsträgerbeweglichkeit im Kanal, die die elektrischen Eigenschaften des Transistors verschlechtert.

In der Regel werden in einer integrierten Schaltung Transistoren mit verschieden elektrische Eigenschaften benötigt, d.h. es müssen bspw. Transistoren mit verschiedenen Kanallängen hergestellt werden. Bekannte Herstellverfahren für derartige vertikale Transistoten sehen vor, für jede Kanallänge eine zusätzliche Maskenebene einzusetzen, und sind daher sehr aufwendig.

Aufgabe der vorliegenden Erfindung ist es daher, einen vertikalen Feldeffekttransistor mit verbesserten elektrischen Eigenschaften anzugeben. Eine weitere Aufgabe ist die Angabe eines entsprechenden Herstellverfahren, mit dem die Herstellung von Transistoren unterschiedlicher Kanallänge ohne den Einsatz zusätzlicher Maskenebenen möglich ist.

Diese Aufgaben werden gelöst durch einen Transistor mit den Merkmalen des Anspruchs 1, bzw. durch ein Verfahren mit den Merkmalen des Anspruchs 8.

Bei dem erfindungsgemäßen Transistor sind Source, Drain und Kanal an der Seitenwand eines Grabens in einem Halbleitersubstrat angeordnet. Die Grabenwände sind isoliert, und zwar ist ein Gatedielektrikum auf dem mittleren Bereich der Grabenwand angeordnet, eine obere Isolationsschicht bzw. eine untere Isolationsschicht sind auf dem oberen bzw. unteren Bereich - also auf dem Source- bzw. dem Drain-Gebiet - angeordnet. Das Gate ist im Innern des Grabens, der sackförmig ausgebildet ist, untergebracht. Das Drain ist ringförmig um den Transistorgraben und anschließend an den Grabenboden ausgebildet. Das Gate füllt nicht den gesamten Graben auf, sondern umschließt ringförmig einen Drainanschluß, der von der Substratoberfäche bis zum Grabenboden reicht. Zwischen Gate und Drainanschluß ist eine Isolierung vorgesehen.

Das Source-Gebiet wird vorzugsweise aus zwei Teilgebieten an gegenüberliegenden Stellen der Grabenwand gebildet, die in geeigneter Weise elektrisch miteinander verbunden sind. Entsprechend befinden sich dann zwei Teilgebiete des Kanals an gegenüberliegenden Grabenwänden. Bei einem Graben mit kreisförmigen Querschnitt können Kanal und Source auch ringförmig um den gesamten Umfang des Grabens verlangen.

Die obere und die untere Isolationsschicht besitzen vorzugsweise eine größere Schichtdicke als das Gatedielektrikum, so daß eine effektive Isolierung zwischen Gate und Source- bzw. Drain-Gebiet gewährleistet ist, d.h. die Gate-Kapazität minimiert ist. Ein weiterer Vorteil ist, daß die Gate-Source- und die Gate-Drain-Kapazitäten lithographieunabhängig sind, da die genannten Isolationsschichten selbstjustiert zum Source- bzw. Drain-Gebiet erzeugt werden.

Der geringe Platzbedarf der Gateelektrode (≥1F², wobei F die minimale Strukturgröße bezeichnet) ermöglicht eine hohe Integrationsdichte derartiger Transistoren. Da der Transistorkanal aus einkristallinem Substrat besteht, weist ein derartiger Transistor gute elektrische Eigenschaften auf, wie lange Lebensdauer, hohe Spannungsfestigkeit und hohe Beweglichkeit der Ladungsträger.

Das Herstellverfahren für den Transistor sieht vor, mit Hilfe einer Maske zunächst den Graben mit der für den Transistor benötigten Tiefe und vorgewähltem Querschnitt herzustellen und an der Grabenwand eine Schutzschicht herzustellen, die die Grabenwand im unteren Bereich, d.h. in der Nähe des Bodens des Grabens, und den Grabenboden freiläßt. Dieser freiliegende, um den gesamten Umfang des Transistorgrabens verlaufende Teil der Grabenwand und der Grabenboden werden dann dotiert mit einem Dotierstoff, der den dem Halbleitersubstrat entgegengesetzten Leitfähigkeitstyp aufweist. Dadurch wird ein Draingebiet erzeugt, das ringförmig um den unteren Bereich des Grabens verläuft und sich an den Grabenboden anschließt. Die Schutzschicht dient als Dotiermaske. Ein geeignetes Dotierverfahren ist insbesondere die Plasmaimmersionsimplantation, oder eine Belegungsdotierung.
Auf der freiliegenden Wand und auf dem Grabenboden wird eine untere Isolationsschicht erzeugt. Die Schutzschicht oder noch verbliebene Teile der Schutzschicht werden entfernt.

Es folgt eine Schrägimplantation in einen oberen Bereich der freiliegenden Grabenwand zur Bildung eines Source-Gebietes. Durch den Implantationswinkel in Kombination mit der Breite des Grabens ergibt sich, bis zu welcher Grabentiefe die Grabenwand dotiert wird, und damit, welche Kanallänge (nicht-implantierter mittlerer Bereich der Grabenwand) verbleibt. Werden auf dem Substrat Gräben vorgegebener Tiefe und unterschiedlicher Breite erzeugt, könne also Transistoren mit unterschiedlichen Kanallängen hergestellt werden, ohne daß eine weitere Maske (z.B. für eine weitere Source- oder Kanalimplantation) notwendig ist.

Die Source-Implantation kann unter dem gleichen Winkel in zwei gegenüberliegende Teile der Grabenwand erfolgen, die so erzeugten Gebiete müssen dann in geeigneter Weise elektrisch verbunden werden. Bei einem Graben mit kreisförmigen Querschnitt kann ein ringförmiges durchgehendes Source-Gebiet durch Implantation in alle Seiten der oberen Grabenwand erzeugt werden.

Vorzugsweise wird gleichzeitig mit der Source-Implantation, bei der ein geeigneter Dotierstoff implantiert wird, Sauerstoff in den oberen Bereich der Grabenwand implantiert. Nach der Schrägimplantation werden das Gatedielektrikum und die obere Isolierschicht erzeugt. Vorzugsweise wird eine thermische Oxidation durchgeführt. Dabei wird dann der implantierte Sauerstoff mit eingebaut, so daß die obere Isolationsschicht dicker als das Gateoxid ist.

Im Innern des Grabens wird das Gate hergestellt, vorzugsweise durch Abscheiden einer dotierten Polysiliziumschicht, die den Graben nicht auffüllt, und anschließendes anisotropes Ätzen. Auf der freien Oberfläche des Gates wird eine Isolierschicht gebildet. Am Grabenboden wird das Drain-Gebiet freigelegt, und der Graben wird mit einer leitenden Schicht zur Bildung des Drain-Anschlusses aufgefüllt.

Vorzugsweise wird als Schutzschicht eine Dreifachschicht, insbesondere bestehend aus Siliziumnitrid/Siliziumoxid/Siliziunitrid verwendet, die auf der Grabenwand und auf den Grabenboden aufgebracht wird. Dann wird die obere Nitridschicht anisotrop und selektiv geätzt, anschließend wird das freiliegende Oxid isotrop entfernt, schließlich wird Nitrid isotrop und selektiv geätzt. Dann verbleibt im oberen und mittleren Bereich der Grabenwand eine Nitrid/Oxid-Doppelschicht, der untere Wandbereich und der Grabenboden liegen frei.

Ein Gatekontakt an der Substratoberfläche erfolgt vorzugsweise an lediglich einer Seite des Grabens, indem bei der Spacerätzung des Gates die Region des späteren Gatekontaktes maskiert wird, so daß hier eine (Polysilizium-)Insel zurückbleibt.

Der Source-Kontakt an der Substratoberfläche kann bspw. dadurch hergestellt werden, daß bei der Dotierung des Drain-Gebietes gleichzeitig ein Bereich der Substratoberfläche anschließend an den Graben dotiert wird. Dieser Bereich ist dann mit dem eigentlichen Source-Bereich an der Grabenwand verbunden und kann als elektrischer Anschluß verwendet werden. Ferner kann dieser Bereich zwei an gegenüberliegenden Teilen der Grabenwand implantierte Source-Gebiete kurzschließen.

Der Drain-Anschluß wird durch eine selbstjustierte Prozeßführung erzeugt. Seine Kontaktfläche nimmt mit abnehmender Kanallänge (d.h. größerer Grabenbreite) zu.

Die Erfindung wird im folgenden anhand eines Ausführungsbeispiels und der Zeichnungen näher erläutert. Es zeigen:
- Figur 1 - 9:: einen Querschnitt durch ein Halbleitersubstrat, an dem die Herstellung des Transistors verdeutlicht wird.
- Figur 10:: zeigt eine schematische Aufsicht auf das Substrat.

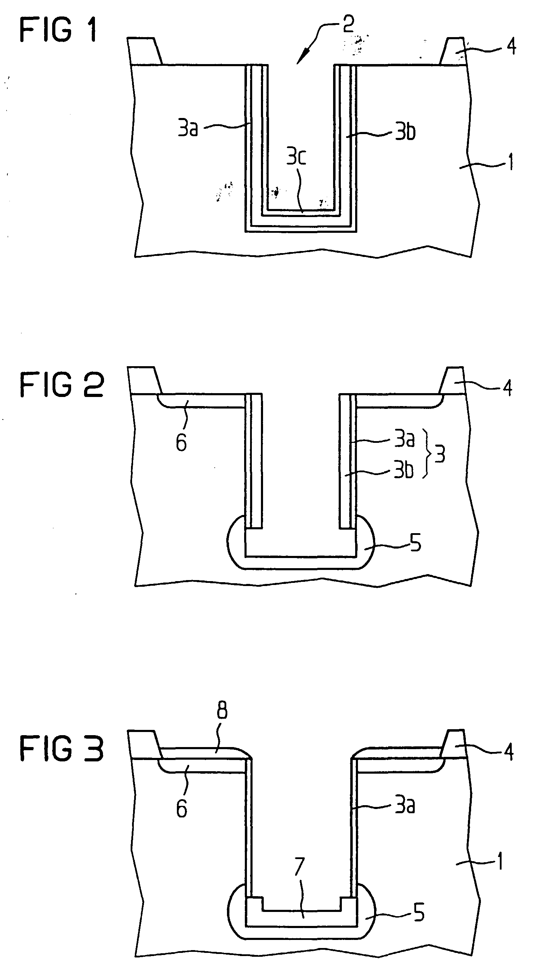

Figur 1: In ein Si-Halbleitersubstrat 1 (p-dotiert) wird mit Hilfe einer üblichen Grabenmaske ein Graben 2 geätzt. Der Graben kann bspw. einen länglichen oder rechteckigen Querschnitt aufweisen, wobei der Durchmesser bzw. die Seitenlänge über einen großen Bereich (≥F)variieren kann. Verschiedene Gräben in demselben Substrat können mit verschiedenen Durchmessern bzw. Seitenlängen zur Erzeugung unterschiedlicher Kanallängen hergestellt werden. Die Tiefe des Grabens kann bspw. im Bereich 0,6 - 1,5 µm liegen. Der Graben wird mit einer Schichtfolge 3 bestehend aus Siliziumnitrid 3a, Siliziumoxid 3b und Siliziumnitrid 3c ausgekleidet, die durch konforme Abscheidung erzeugt wird. Auf der Substratoberfläche wird diese Schichtfolge vorzugsweise durch einen CMP-Schritt (chemical mechanical polishing) wieder entfernt. Die Schichtdicken liegen vorzugsweise jeweils im Bereich 10 - 80 nm. Dann wird auf die Subtratoberfläche eine weitere Schicht 4, insbesondere eine Oxidschicht von etwa 100 - 400 nm Dicke, aufgebracht, die im Graben und in einer Umgebung des Grabens wieder entfernt wird.

Figur 2: Es wird zunächst die obere Nitridschicht 3c anisotrop und selektiv zur Oxidschicht geätzt, anschließend wird das freiliegende Oxid 3b mit einem isotropen Äztprozeß selektiv zum Nitrid 3c und 3a entfernt. Bei diesem Oxidätzprozeß wird auch die Oxidschicht 4 etwas gedünnt. Schließlich werden mit einer isotropen Nitridätzung selektiv zum Oxid 3b an den Seitenwänden das Decknitrid 3c und am Grabenboden das freiliegende Grundnitrid 3a entfernt. Dadurch erhält man eine Schutzschicht 3 (bestehend aus dem Oxid 3b und dem Grundnitrid 3a), die den Boden und den unteren Bereich der Grabenwand freiläßt, wobei die vertikale Ausdehnung der freigelegten Grabenwand in etwa der Schichtdicke der Schutzschicht bzw. der anfänglichen Dreifachschicht entspricht. Die Schutzschicht 3 dient als Maske für die Dotierung des Drains. Es wird vorzugsweise eine Plasmaimmersionsimplantation mit Ionen eines n-leitenden Dotierstoffs eingesetzt. Dadurch wird am Grabenboden und im unteren Bereich der Grabenwand ein Draingebiet 5 gebildet. Insgesamt umschließt sich das Draingebiet den unteren Grabenbereich. Gleichzeitig wird benachbart zum Graben an der Substratoberfläche ein n-dotiertes Gebiet 6 erzeugt, das später als Anschluß für das Source-Gebiet verwendet werden kann. Die Größe dieses dotierten Gebietes 6 ist durch die Öffnung in der weiteren Schicht 4 definiert.

Figur 3: Die noch an der Grabenwand befindliche Oxidschicht 3b wird entfernt, dann wird eine thermische Oxidation durchgeführt. Dabei wird im unteren Bereich des Grabens eine untere Isolationsschicht 7 gebildet, die hier die Grabenwand und den Grabenboden bedeckt. Ihre Dicke liegt bspw. im Bereich 30 - 100 nm. Gleichzeitig wird auf dem dotierten Gebiet 6 an der Substratoberfläche ein Oxid 8 gebildet. An der Wand im oberen und mittleren Grabenbereich wird kein Oxid gebildet, da hier die Niridschicht 3a als Oxidationsmaske wirkt.

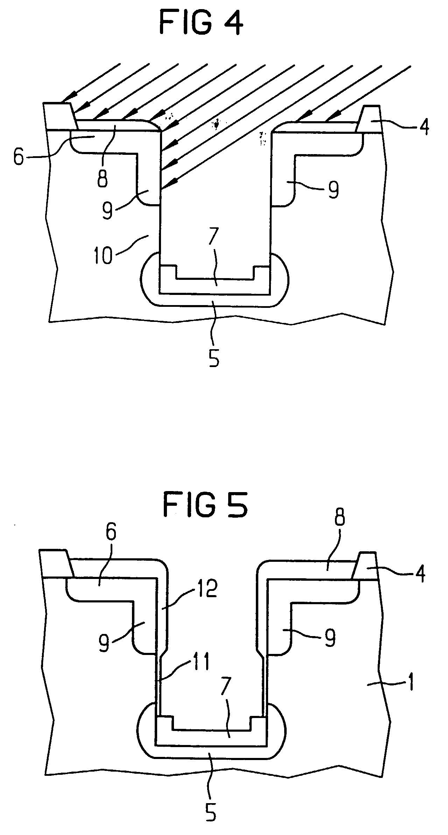

Figur 4: Die restliche Nitridschicht 3a wird nun entfernt. Es wird eine Implantation mit n-dotierenden Ionen in einen oberen Bereich der Grabenwand durchgeführt. Es werden zwei gegenüberliegende Teile (Seiten) der Grabenwand bis zur selben Grabentiefe implantiert. Das vertkale Ausmaß des dadurch erzeugten Source-Gebietes 9 (das hier aus zwei Teilgebieten besteht) wird dabei durch den Implantationswinkel und die Grabenbreite vorgegeben. Bei verschieden breiten Gräben reichen also die jeweiligen Source-Gebiete verschieden tief in den Graben, so daß der verbleibende mittlere Bereich 10 der Grabenwand, der die Dotierung des Substrats aufweist und den Kanalbereich des Transistors bildet, verschieden lang (vertikal zur Substratoberfläche) ist. Damit sind mit einer einzigen Schrägimplantation (ggf. in gegenüberliegende Grabenwände) verschiedene Kanallängen 10 erzeugbar. Gleichzeitig mit dem Dotierstoff - also mit demselben Implantationswinkel - kann Sauerstoff implantiert werden, der in die Grabenwand eingebaut wird. Seine Implantationsenergie wird so gewählt, daß er in der Nähe der Wandoberfläche verbleibt.

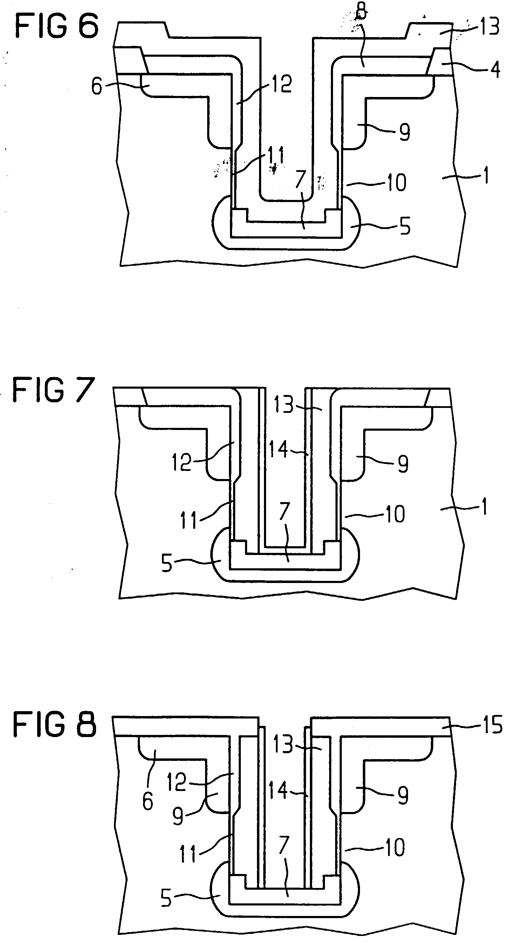

Figur 5: Durch einen Oxidationsschritt wird im mittleren Bereich der Grabenwand ein Gateoxid 11 erzeugt, im oberen Bereich der Grabenwand wird dabei eine obere Isolationsschicht 12 erzeugt. Durch den Einbau des implantierten Sauerstoffs ist die obere Isolationsschicht dicker als das Gateoxid. Je nach Prozeßbedingungen wird auch das auf dem dotierten Gebiet 6 angeordnete Oxid 8 verdickt.

Figur 6: Dann wird ganzflächig eine als Gatematerial geeignete leitende Schicht 13, insbesondere dotiertes Polysilizium, aufgebracht. Die Schichtdicke wird so gewählt, daß der Graben nicht aufgefüllt wird.

Figur 7: Das Polysilizium 13 wird anisotrop geätzt, so daß am Grabenboden die untere Isolationsschicht 7 freigelegt wird und an der Grabenwand ein ringförmiger Polysilizium-Spacer 13 stehenbleibt. Dieser Spacer 13 bildt das Gate. Vorzugsweise wird bei der Spacerätzung ein Teil des Grabens und eine daran anschließende Region der Substratoberfläche mit einer Maske bedeckt, so daß hier das Polysilizium 13 ebenfalls stehenbleibt und als Anschluß für das Gate dienen kann (in Fig 7 außerhalb der Zeichenebene). Anschließend wird als Isolierung auf dem Gate 13 ganzflächig eine Nitridschicht 14 abgeschieden. Auf der Substratoberfläche wird dieses Nitrid bspw. mittels CMP wieder entfernt. Dazu kann z.B. CMP eingesetzt werden, wenn der Gateanschluß vorher vertieft erzeugt wurde.

Figur 8: Die gesamte Anordnung wird einem Oxidationsschritt unterworfen, bei dem auf der Substratoberfläche ein Oxid 15 gebildet wird, das dicker ist als die untere Isolationsschicht 7.Das Nitrid 14 wirkt als Oxidationsmaske. Anschließend wird das Nitrid anisotrop geätzt, so daß am Grabenboden die untere Isolationschicht 7 freigelegt wird.

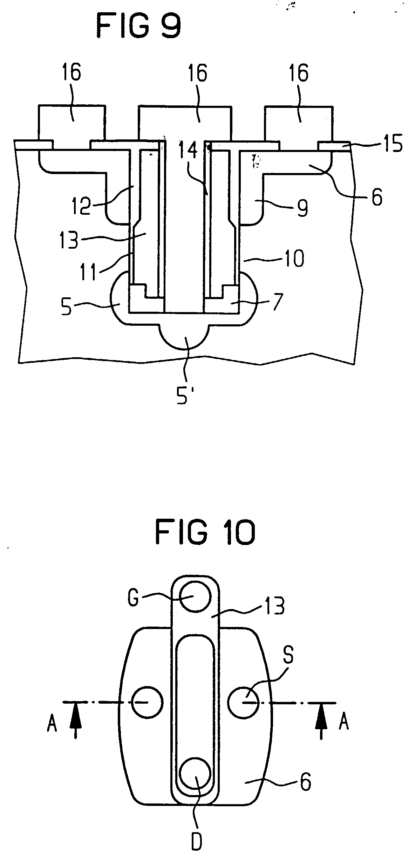

Figur 9: Es wird eine anisotrope, vorzugsweise ganzflächige Oxidätzung durchgeführt, bis am Grabenboden ein Teil des Drain-Gebietes 5 freigelegt ist. Auf der Substratoberfläche verbleibt noch eine Restdicke der Oxidschicht 15. In diese Oxidschicht werden Kontaktlöcher für den Anschluß des Source-Gebietes über das dotierte Gebiet 6 und für den Gate-Anschluß (s. Fig. 10) geätzt. Es können Kontaktimplantationen zur Verringerung des Übergangswiderstandes in den Kontaktlöchern vorgenommen werden, dadurch wird auch der dargestellte Bereich 5' gebildet. Schließlich wird eine leitende Schicht 16, bspw. ein geeignetes Metall, aufgebracht, mit dem die Kontakte zu Source, Drain und Gate erzeugt werden.

Figur 10: zeigt die Lage des dotierten Gebietes 6, des Polysiliziums 13 und der vorgesehenen Anschlüsse S, D und G für Source, Drain und Gate schematisch in einer Aufsicht auf die Substratoberfläche. Der Schnitt für die Figuren 1 - 9 verläuft entlang der Linie A - A.

## Patentansprüche

1. Vertikaler MOS-Transistor im einem Halbleitersubstrat (1),
- bei dem das Substrat einen Graben (2) aufweist, der sich von der Substratoberfläche in die Tiefe erstreckt,
- bei dem ein Drain-Gebiet (5) von einem dotierten Bereich im Halbleitersubstrat (1) anschließend an den Grabenboden und an einen unteren Bereich der Grabenwand über den gesamten Umfang gebildet wird,
- bei dem ein Source-Gebiet (9) von einem dotierten Bereich des Halbleitersubstrats anschließend an die Grabenwand im oberen Bereich des Grabens gebildet wird,
- bei dem ein Kanalgebiet (10) von einem Bereich des Halbleitersubstrats anschließend an die Grabenwand im mittleren Bereich des Grabens gebildet wird,
- bei dem ein Gate (13) in Inneren des Grabens (2) angeordnet ist und durch eine obere (12) bzw. untere Isolierschicht (7) vom Source- bzw. Draingebiet und durch ein Gatedielektrikum (11) vom Kanalgebiet isoliert ist,
- bei dem das Gate (13) einen vom Gate isolierten Drain-Anschluß(16), der sich von der Substratoberfläche bis zum Drain-Gebiet (5) erstreckt, ringförmig umschließt.

2. Transistor nach Anspruch 1, bei dem die obere (12) und die untere Isolierschicht (7) und das Gatedielektrikum (11) aus thermischem Siliziumoxid bestehen.

3. Transistor nach einem der Ansprüche 1 bis 2, bei dem der Drain-Anschluß durch eine Siliziumnitridschicht (14) vom Gate isoliert ist.

4. Transistor nach einem der Ansprüche 1 bis 3, bei dem das Source-Gebiet über ein mit ihn verbundenes dotiertes Gebiet (6) an der Substratoberfläche anschließbar ist.

5. Transistor nach einem der Ansprüche 1 bis 4, bei dem das Source-Gebiet (9) zwei Teilgebiete an gegenüberliegenden Stellen der Grabenwand aufweist, die leitend miteinander verbunden sind.

6. Transistor nach einem der Ansprüche 1 bis 5, bei dem die Kanallänge mittels der Breite des Grabens (2) einstellbar ist.

7. Transistor nach einem der Ansprüche 1 bis 6, bei den der Graben (2) einen kreisförmigen Querschnitt aufweist und bei dem das Source-Gebiet (9) und das Kanalgebiet (10) den Graben ringförmig umschließen.

8. Herstellverfahren für einen Transistor nach einem der Ansprüche 1 bis 7, mit folgenden Schritten:
- Erzeugen eines Grabens (2) im Halbleitersubstrat (1),
- Erzeugen einer Schutzschicht (3) an der Grabenwand, die die Grabenwand im unteren Grabenbereich und den Grabenboden freiläßt,
- Erzeugen eines Drain-Gebietes (5) durch Dotieren der freiliegenden Grabenwand und des Grabenbodens, und Entfernen der Schutzschicht (3),
- Erzeugen einer unteren Isolationsschicht (7) auf dem Drain-Gebiet,
- Erzeugen eines Source-Gebietes (9) durch schräge Implantation in den oberen Bereich der Grabenwand,
- Erzeugen eines Gatedielektrikums (11) auf der Grabenwand und einer oberen Isolationsschicht (12)auf dem Source-Gebiet,
- Erzeugen eines Gates (13) auf der Grabenwand, das den Graben nicht auffüllt,
- Erzeugen einer Isolierung (14) auf dem Gate,
- Freilegen des Grabenbodens und Auffüllen des Grabens mit einer leitenden Schicht (16) zur Bildung eines Drain-Anschlusses

9. Verfahren nach Anspruch 8,
- bei dem zur Erzeugung der Schutzschicht (3) mehrere Teilschichten (3a, 3b, 3c) an der Wand und auf dem Boden des Grabens aufgebracht werden,
- bei dem dann die oberste Teilschicht (3c) durch anisotropes Ätzen auf dem Grabenboden entfernt wird,
- bei dem dann eine darunterliegende Teilschicht (3b, 3c) durch isotropes Ätzen auf dem Grabenboden und im unteren Bereich der Grabenwand entfernt wird.

10. Verfahren nach Anspruch 9, bei dem die Schutzschicht aus einer Dreifachschicht bestehend aus Siliziumnitrid/ Siliziumoxid/Siliziumnitrid besteht.

11. Verfahren nach einem der Ansprüche 8 bis 10, bei dem nach Fertigstellung des Drain-Gebietes (5) auf dem Grabenboden und vor der vollständigen Entfernung der Schutzschicht (3) ein thermisches Oxyd als untere Isolationsschicht (7) erzeugt wird.

12. Verfahren nach einem der Ansprüche 8 bis 11, bei dem die Kanallänge des Transistors durch den Implantationswinkel bei der Erzeugung des Source-Gebietes (9) und/oder durch die Grabenbreite eingestellt wird.

13. Verfahren nach einem der Ansprüche 8 bis 12, bei dem zur Erzeugung der oberen Isolationschicht (12) bei der Implantation des Source-Gebietes Sauerstoff implantiert wird.

14. Verfahren nach einem der Ansprüche 8 bis 13, bei dem ein dotiertes Gebiet (6) an der Substratoberfläche anschließend an den Graben hergestellt wird, das mit dem Source-Gebiet (9) verbunden wird und als Anschluß für das Source-Gebiet verwendet wird.

15. Verfahren nach einem der Ansprüche 8 bis 14, bei dem zur Erzeugung des Source-Gebiets in zwei gegenüberliegende Bereiche der oberen Grabenwand unter dem gleichen Winkel implantiert wird.

16. Verfahren nach einem der Ansprüche 8 bis 14, bei dem ein Graben mit kreisförmigen Querschnitt gebildet wird und zur Erzeugung des Source-Gebiets ein ringförmiger Bereich der oberen Grabenwand implantiert wird.
